# EUROPEAN PATENT APPLICATION

(11) **EP 4 215 571 A1**
(43) Date of publication of application: **26.07.2023**
(21) Application number: 21894823.0
(22) Date of filing: 17.08.2021
(51) Int. Cl.: C08J 5/18, C08G 73/10, C08K 5/5397, C08L 79/08, G09F 9/30

(54) **POLYIMIDE RESIN FILM, AND FLEXIBLE DISPLAY DEVICE SUBSTRATE AND FLEXIBLE DISPLAY DEVICE, USING SAME**

(30) Priority: 18.11.2020 KR 20200154457; 11.08.2021 KR 20210106253
(71) Applicant: LG Chem, Ltd., Seoul 07336 (KR)
(72) Inventor: PARK, Hye Jin, Daejeon 34122 (KR)
(74) Representative: Goddar, Heinz J.
(86) International application number: PCT/KR2021/010878
(87) International publication number: WO 2022/108046

(57) **Abstract**

The present disclosure relates to a polyimide polymer film capable of realizing excellent optical properties and high heat resistance, a substrate for flexible display device and a flexible display device using the same.

## Description

### [TECHNICAL FIELD]

### CROSS-REFERENCE TO RELATED APPLICATION(S)

This application claims the benefit of Korean Patent Application No. 10-2020-0154457 filed' on November 18, 2020 and Korean Patent Application No. 10-2021-0106253 filed on August 11, 2021 in the Korean Intellectual Property Office, the disclosures of which are incorporated herein by reference in their entirety.

The present disclosure relates to a polyimide polymer film capable of realizing excellent optical properties and high heat resistance, a substrate for flexible display device and a flexible display device using the same.

### [BACKGROUND ART]

The display device market is rapidly changing based on flat panel displays(FPDs) that that are easy to fabricate over a large area and can be reduced in thickness and weight. Such flat panel displays include liquid crystal displays (LCDs), organic light emitting displays (OLEDs), or electrophoretic devices (EPDs).

In line with recent efforts to further extend the application and use of flat panel displays, particular attention has focused on so-called flexible display devices in which flexible substrates are applied to flat panel displays. The application of such flexible display devices is particularly reviewed based on mobile devices such as smart phones and the application fields thereof are gradually extended.

Generally, when producing a flexible display device and an illumination device, a multilayer inorganic film such as a buffer layer, an active layer, and a gate insulator is formed on the cured polyimide to produce a TFT device.

However, a flexible type display shows problems such as a restored after-image due to the application of a plastic substrate. Further, the plastic material substrate is problematic in that heat resistance, thermal conductivity, and electrical insulation are deteriorated as compared as those of the glass substrate.

Nevertheless, studies are actively conducted to replace glass substrates and apply a plastic substrate having the advantage of being light and flexible, and capable of being producing by a continuous process, to a mobile phone, a notebook PC, a TV, and the like.

Polyimide polymer has an advantage that it is easy to synthesize, can be produced into a thin film, and can be applied to a high temperature process. In line with the trend of light weight and refinement of various electronic devices, the polyimide polymer is widely applied as an integrated material for semiconductor materials. In particular, many studies are underway to apply the polyimide polymer to a flexible plastic display board that requires light and flexible properties.

### [DETAILED DESCRIPTION OF THE INVENTION]

### [Technical Problem]

It is an object of the present disclosure to provide a polyimide polymer film capable of realizing excellent optical properties and high heat resistance.

It is another object of the present disclosure to provide a substrate for flexible display device and a flexible display device using the polyimide polymer film.

### [Technical Solution]

In order to achieve the above objects, according to one aspect of the present disclosure, there is provided a polyimide polymer film comprising: a polyimide polymer which comprises a repeating unit derived from a reaction product between three or more aromatic tetracarboxylic acids having different structures or derivatives thereof and aromatic diamines, wherein a transmittance at wavelengths of 450 nm and 550 nm is 70% or more, respectively, a coefficient of thermal expansion in the temperature range of 100°C or more and 400°C or less is -10 ppm/°C or more and 30 ppm/°C or less, and a glass transition temperature is 400°C or more.

According to another aspect, there is provided a substrate for flexible display device including the above-mentioned polyimide polymer film.
According to yet another aspect, there is provided a flexible display device including the above-mentioned polyimide polymer film.

Hereinafter, a polyimide polymer film, a substrate for flexible display device and a flexible display device using the same according to specific embodiments of the present disclosure will be described in more detail.

Unless otherwise specified throughout this specification, the technical terms used herein are only for reference to specific embodiments and is not intended to limit the present disclosure.

The singular forms "a", "an", and "the" used herein include plural references unless the context clearly dictates otherwise.

The term "including" or "comprising" used herein specifies a specific feature, region, integer, step, action, element and/or component, but does not exclude the presence or addition of a different specific feature, region, integer, step, action, element, component and/or group.

The terms including ordinal numbers such as "a first", "a second", etc. are used only for the purpose of distinguishing one component from another component, and are not limited by the ordinal numbers. For instance, a first component may be referred to as a second component, or similarly, the second component may be referred to as the first component, without departing from the scope of the present disclosure.

In the present disclosure, the (co)polymer means including both a polymer and a copolymer, the polymer means a homopolymer consisting of a single repeating unit, and the copolymer means a composite polymer containing two or more repeating units.

In the present disclosure, examples of the substituents are described below, but are not limited thereto.

In the present disclosure, the term "substituted" means that other functional groups instead of a hydrogen atom in the compound are bonded, and a position to be substituted is not limited as long as the position is a position at which the hydrogen atom is substituted, that is, a position at which the substituent can be substituted, and when two or more are substituted, the two or more substituents may be the same as or different from each other.

In the present disclosure, the term "substituted or unsubstituted" means being unsubstituted or substituted with one or more substituents selected from the group consisting of deuterium; a halogen group; a cyano group; a nitro group; a hydroxyl group; a carbonyl group; an ester group; an imide group; an amide group; a primary amino group; a carboxy group; a sulfonic acid group; a sulfonamide group; a phosphine oxide group; an alkoxy group; an aryloxy group; an alkylthioxy group; an arylthioxy group; an alkylsulfoxy group; an arylsulfoxy group; a silyl group; a boron group; an alkyl group; a cycloalkyl group; an alkenyl group; an aryl group; an aralkyl group; an aralkenyl group; an alkylaryl group; an alkoxysilylalkyl group; an arylphosphine group; or a heterocyclic group containing at least one of N, O, and S atoms, or being unsubstituted or substituted with a substituent to which two or more substituents are linked among the substituents exemplified above. For example, "the substituent to which two or more substituents are linked" may be a biphenyl group. That is, the biphenyl group may also be an aryl group, and may be interpreted as a substituent to which two phenyl groups are linked.

In the present disclosure, the notation 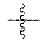 , or 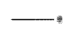 means a bond linked to another substituent group, and a direct bond means the case where no other atoms exist in the parts represented as L.

In the present disclosure, an aromatic is a property that satisfies Huckle's Rule, and a compound can be defined as aromatic if all of the following three conditions are satisfied according to Huckle's Rule.
1) There must be 4n+2 electrons that are completely conjugated by empty p-orbitals, unsaturated bonds, lone electron pairs, etc.
2) 4n+2 electrons have to form planar isomers and form a ring structure.
3) All atoms of the ring have to be able to participate in conjugation.

In the present disclosure, the alkyl group is a monovalent functional group derived from an alkane, and may be a straight-chain or a branched-chain. The number of carbon atoms of the straight chain alkyl group is not particularly limited, but is preferably 1 to 20. Also, the number of carbon atoms of the branched chain alkyl group is 3 to 20. Specific examples of the alkyl group include methyl, ethyl, propyl, n-propyl, isopropyl, butyl, n-butyl, isobutyl, tert-butyl, sec-butyl, 1-methyl-butyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 2-methylpentyl, 4-methylhexyl, 5-methylhexyl, 2,6-dimethylheptane-4-yl and the like, but are not limited thereto. The alkyl group may be substituted or unsubstituted, and when substituted, examples of the substituent are the same as described above.

In the present disclosure, the haloalkyl group means a functional group in which the above-mentioned alkyl group is substituted by a halogen group, and examples of the halogen group are fluorine, chlorine, bromine or iodine. The haloalkyl group may be substituted or unsubstituted, and when substituted, examples of the substituent are the same as described above.

In the present disclosure, a multivalent functional group is a residue in which a plurality of hydrogen atoms bonded to an arbitrary compound are removed, and for example, it may be a divalent functional group, a trivalent functional group, and a tetravalent functional group. As an example, a tetravalent functional group derived from a cyclobutane means a residue in which any four hydrogen atoms bonded to the cyclobutane are removed.

In the present disclosure, the electron-withdrawing group may include one or more selected from the group consisting of a haloalkyl group, a halogen group, a cyano group, a nitro group, a sulfonic acid group, a carbonyl group, and a sulfonyl group, and preferably, it may be a haloalkyl group such as trifluororumethyl group (-CF₃).

In the present specification, a direct bond or a single bond means being connected to a bond line in which no atoms or atomic groups exist at the corresponding position. Specifically, it means the case where no other atoms exist in the parts represented as L₁, or L₂ in Chemical Formula.

In the present specification, the weight average molecular weight means a weight average molecular weight in terms of polystyrene measured by GPC method. In the process of determining the weight average molecular weight in terms of polystyrene measured by the GPC method, a commonly known analyzing device, a detector such as a refractive index detector, and an analytical column can be used. Commonly applied conditions for temperature, solvent, and flow rate can be used. Specific examples of the measurement condition are as follows: Waters PL-GPC220 instrument was used and a Polymer Laboratories PLgel MIX-B 300 mm length column was used. An evaluation temperature was 160°C, and 1,2,4-trichlorobenzene was used for a solvent at a flow rate of 1 mL/min. Samples were prepared at a concentration of 10 mg/10 mL and then supplied in an amount of 200 µL, and the values of Mw could be determined using a calibration curve formed using a polystyrene standard. 9 kinds of the polystyrene standard were used with the molecular weight of 2,000 / 10,000 / 30,000 / 70,000 / 200,000 / 700,000 / 2,000,000 / 4,000,000 / 10,000,000.

Hereinafter, the present disclosure will be described in more detail.

According to one embodiment of the present disclosure, there can be provided a polyimide polymer film comprising: a polyimide polymer which comprises a repeating unit derived from a reaction product between three or more aromatic tetracarboxylic acids having different structures or derivatives thereof and aromatic diamines, wherein a transmittance at wavelengths of 450 nm and 550 nm is 70% or more, respectively, a coefficient of thermal expansion in the temperature range of 100°C or more and 400°C or less is -10 ppm/°C or more and 30 ppm/°C or less, and a glass transition temperature is 400°C or more.

The present inventors have found through experiments that as in the polyimide polymer film of the above-mentioned one embodiment, by satisfying the features that a transmittance at wavelengths of 450 nm and 550 nm is 70% or more, respectively, a coefficient of thermal expansion in the temperature range of 100°C or more and 400°C or less is -10 ppm/°C or more and 30 ppm/°C or less, and a glass transition temperature is 400°C or more, it is possible to realize excellent optical properties that are colorless transparent through low yellowness and excellent transmittance, and at the same time, exhibit a low coefficient of thermal expansion and thus realize high heat resistance, thereby completing the present disclosure.

The polyimide polymer is meant to include both a polyimide, and a precursor polymer thereof such as polyamic acid ester or polyamic acid ester. That is, the polyimide polymer may include at least one selected from the group consisting of a polyamic acid repeating unit, a polyamic acid ester repeating unit, and a polyimide repeating unit. That is, the polyimide-based polymer may include one type of polyamic acid repeating unit, one type of polyamic acid ester repeating unit, one type of polyimide repeating unit, or a copolymer in which these two or more types of repeating units are mixed.

The one or more repeating units selected from the group consisting of the polyamic acid repeating unit, the polyamic acid ester repeating unit, and the polyimide repeating unit can form a main chain of the polyimide polymer.

The polyimide polymer film may include a cured product of the polyimide polymer. The cured product of the polyimide polymer means a product obtained through the curing process of the polyimide polymer.

As described above, the polyimide polymer film may include a repeating unit containing at least one selected from the group consisting of a repeating unit represented by the following Chemical Formula 1, a repeating unit represented by the following Chemical Formula 2, and a repeating unit represented by the following Chemical Formula 3; a polyimide repeating unit represented by the following Chemical Formula 4; and a polyimide repeating unit represented by the following Chemical Formula 5: 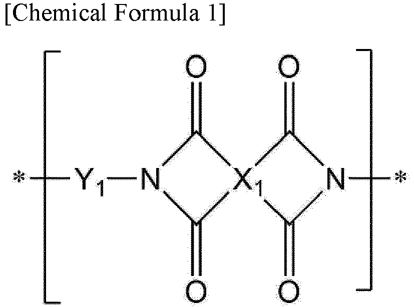 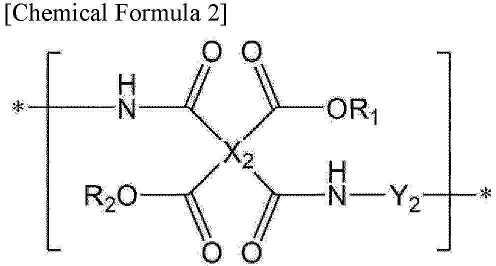 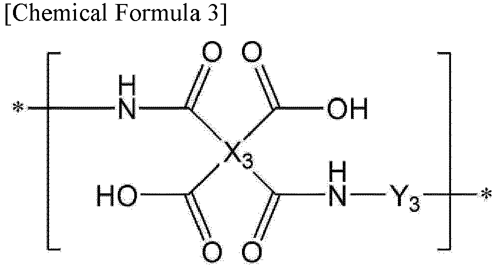
wherein, in Chemical Formulas 1 to 3, at least one of R₁ and R₂ is an alkyl group having 1 to 10 carbon atoms, the rest is hydrogen, X₁ to X₃ are each independently a tetravalent organic group including a tetravalent functional group represented by the following Chemical Formula 6, wherein the Y₁ to Y₃ are each independently a divalent organic group in which at least one fluorine-based functional group is substituted, 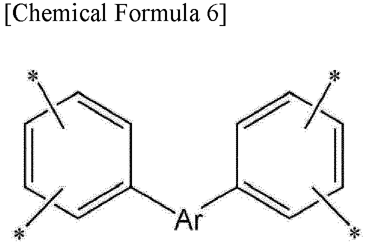
wherein, in Chemical Formula 6, Ar is a polycyclic aromatic divalent functional group, 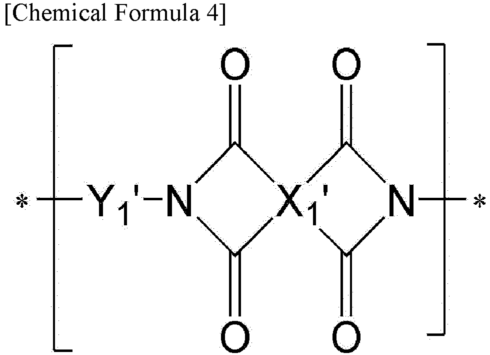
wherein, in Chemical Formula 4,
X₁' is an aromatic tetravalent functional group having 8 or less carbon atoms,
Y₁' is an aromatic divalent functional group in which at least one fluorine-based functional group is substituted, 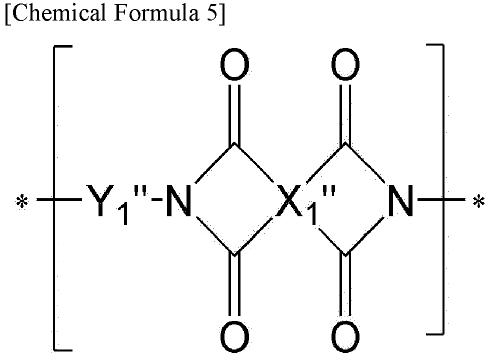
wherein, in Chemical Formula 5,
X₁" is an aromatic tetravalent functional group having 9 or more and 15 or less carbon atoms, and
Y₁" is an aromatic divalent functional group in which at least one fluorine-based functional group is substituted.

As the polyimide polymer includes the polyimide repeating unit represented by Chemical Formula 4, and the polyimide repeating unit represented by Chemical Formula 5, together with a repeating unit containing at least one selected from the group consisting of the repeating unit represented by Chemical Formula 1, the repeating unit represented by Chemical Formula 2, and the repeating unit represented by Chemical Formula 3, it is possible to exhibit excellent optical properties and at the same time realize high heat resistance.

In Chemical Formulas 1 to 3, X₁ to X₃ are each independently a tetravalent organic group including the tetravalent functional group represented by Chemical Formula 6, wherein the X₁ to X₃ are functional groups derived from a tetracarboxylic dianhydride compound used in the synthesis of polyimide polymers.

When the tetravalent functional group represented by Chemical Formula 6 is included in the X₁ to X₃, an asymmetric structure having increased steric hindrance due to a polycyclic ring is introduced into the polyimide chain structure, thereby capable of reducing the difference in refractive index between the plane direction and the thickness direction, and realizing a low phase difference.

In Chemical Formula 6, Ar is a polycyclic aromatic divalent functional group. The polycyclic aromatic divalent functional group is a divalent functional group derived from a polycyclic aromatic hydrocarbon compound or a derivative compound thereof, and may include a fluorenylene group. The derivative compound includes all compounds in which one or more substituents are introduced or a carbon atom is replaced with a heteroatom.

More specifically, in Ar of Chemical Formula 6, the polycyclic aromatic divalent functional group may include a fused cyclic divalent functional group containing at least two or more aromatic cyclic compounds. That is, the polycyclic aromatic divalent functional group may contain at least two or more aromatic ring compounds in the functional group structure, and also the functional group may have a fused ring structure.

The aromatic cyclic compound may include an arene compound containing one or more benzene rings, or a hetero arene compound in which carbon atoms in the arene compound are replaced with heteroatoms.

The aromatic cyclic compound may contain at least two or more in the polycyclic aromatic divalent functional group, and each of the two or more aromatic cyclic compounds can directly form a fused ring, or can form a fused ring via another ring structure. As an example, when two benzene rings are each fused to a cycloalkyl ring structure, it can be defined that two benzene rings have formed a fused ring via cycloalkyl ring.

The fused cyclic divalent functional group containing at least two or more aromatic cyclic compounds is a divalent functional group derived from a fused cyclic compound or a derivative compound thereof containing at least two or more aromatic cyclic compounds, and the derivative compound includes all compounds in which one or more substituents are introduced or a carbon atom is replaced with a heteroatom.

In one example, the tetravalent functional group represented by Chemical Formula 6 may include a functional group represented by the following Chemical Formula 6-1.

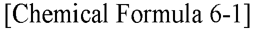

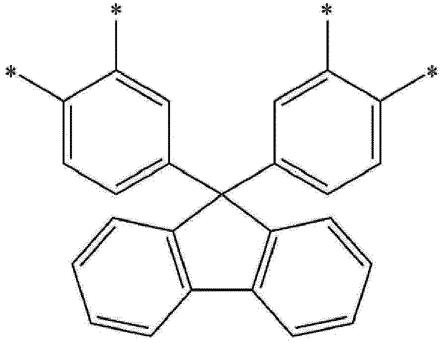

Meanwhile, in Chemical Formulas 1 to 3, Y₁ to Y₃ are each independently a divalent organic group in which at least one fluorine-based functional group is substituted, wherein the Y₁ to Y₃ may be functional groups derived from a diamine compound used in the synthesis of polyamic acid, polyamic acid ester, or polyimide.

As the fluorine-based functional group such as trifluororumethyl group (-CF₃) having high electronegativity are substituted, the effect of suppressing the formation of CTC (charge transfer complex) of Pi-electrons existing in the polyimide polymer chain is increased, thereby ensuring improved transparency. That is, the packing in the polyimide structure or between the chains can be reduced, and due to steric hindrance and electrical effects, it is possible to weaken the electrical interaction between the chromophores and show high transparency in the visible region.

Specifically, the divalent organic group in which at least one fluorine-based functional group is substituted may include a functional group represented by the following Chemical Formula 7. 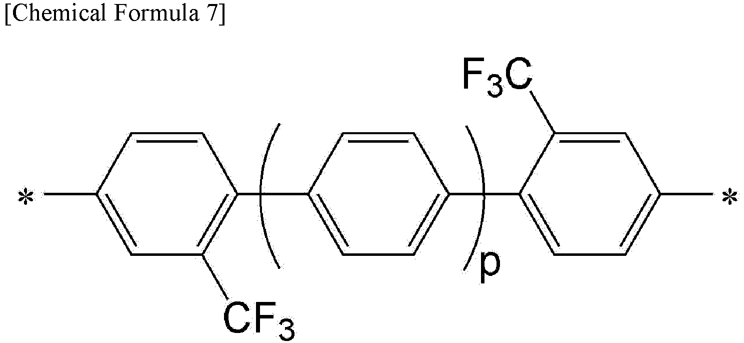 wherein, in Chemical Formula 7, P is an integer of 0 or more and 5 or less.

More specifically, the polyimide polymer has a feature that a terminal anhydride group (-OC-O-CO-) of the tetracarboxylic dianhydride can be reacted with a terminal amino group (-NH₂) of the aromatic diamine in which at least one fluorine-based functional group is substituted, thereby forming a bond between the nitrogen atom of the amino group and the carbon atom of the anhydride group.

That is, the polyimide polymer may include a combination of tetracarboxylic dianhydride represented by the following Chemical Formula 10 and an aromatic diamine in which at least one fluorine-based functional group is substituted. 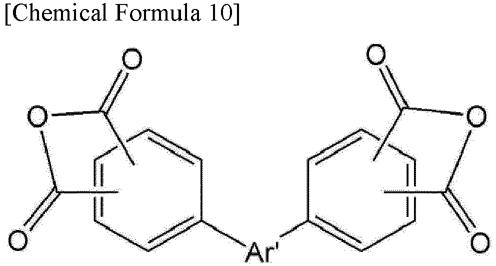 wherein, in Chemical Formula 10, Ar' is a polycyclic aromatic divalent functional group.

The polycyclic aromatic divalent functional group is a divalent functional group derived from a polycyclic aromatic hydrocarbon compound, which is a divalent functional group derived from a fluorene or a derivative compound thereof, and may include a fluorenylene group. The derivative compound includes all compounds in which one or more substituents are introduced or a carbon atom is replaced with a heteroatom.

Specific examples of the tetracarboxylic dianhydride represented by Chemical Formula 10 include 9,9-bis(3,4-dicarboxyphenyl)fluorene dianhydride (BPAF).

The aromatic diamine in which at least one fluorine-based functional group is substituted is a compound in which an amino group (-NH₂) is bonded to both terminals of the aromatic divalent functional group in which at least one fluorine-based functional group is substituted. Details of the aromatic divalent functional group in which at least one fluorine-based functional group is substituted are the same as described above.

More specifically, the polyimide polymer has a feature in which a terminal anhydride group (-OC-O-CO-) of the tetracarboxylic dianhydride represented by Chemical Formula 10 can be reacted with a terminal amino group (-NH₂) of the aromatic diamine in which at least one fluorine-based functional group is substituted, thereby forming a bond between the nitrogen atom of the amino group and the carbon atom of the anhydride group.

The X₁' may be an aromatic tetravalent functional group having 8 or less carbon atoms, and the X₁" may be an aromatic tetravalent functional group having 9 or more and 15 or less carbon atoms.

For example, the aromatic tetravalent functional group may be one of the tetravalent functional groups represented by the following Chemical Formula 13. 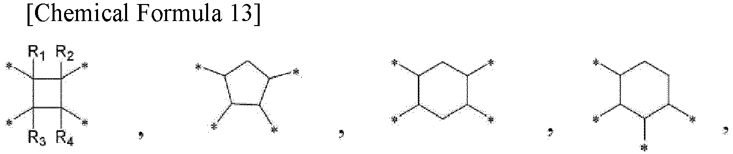 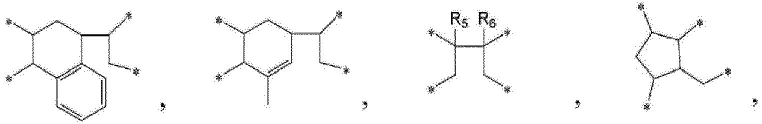 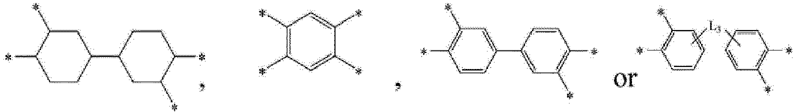 wherein, in Chemical Formula 11, R₁ to R₆ are each independently hydrogen or an alkyl group having 1 to 6 carbon atoms, L₃ is any one selected from the group consisting of a single bond, -O-, -CO-, -COO-, -S-, -SO-, -SO₂-, -CR₇R₈-, -(CH₂)ₜ-, - O(CH₂)ₜO-, -COO(CH₂)ₜOCO-, -CONH-, phenylene or a combination thereof, where R₇ and R₈ are each independently one of hydrogen, an alkyl group having 1 to 10 carbon atoms, or a haloalkyl group having 1 to 10 carbon atoms, and t is an integer of 1 to 10.

Specifically, the aromatic tetravalent functional group having 8 or less carbon atoms may include a functional group represented by the following Chemical Formula 10.

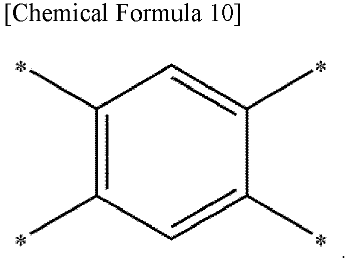

That is, the polyimide polymer may include a polyimide repeating unit including an aromatic tetravalent functional group having 8 or less carbon atoms including a functional group represented by Chemical Formula 10.

More specifically, the aromatic tetravalent functional group having 9 or more and 15 or less carbon atoms may be a functional group represented by the following Chemical Formula 11. 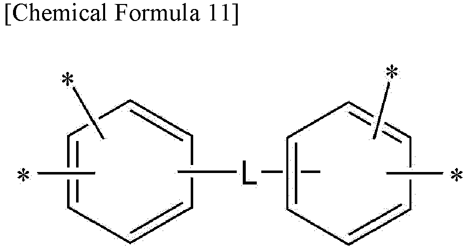 wherein, in Chemical Formula 11, L is any one selected from the group consisting of a single bond, -O-, -CO-, -COO-, -S-, -SO-, -SO₂-, -CR₇R₈-, -(CH₂)ₜ-, -O(CH₂)ₜO-, - COO(CH₂)ₜOCO-, -CONH-, phenylene or a combination thereof, and t is an integer of 1 to 10.

That is, the polyimide polymer may include a polyimide repeating unit including an aromatic tetravalent functional group having 9 or more and 15 or less carbon atoms including a functional group represented by Chemical Formula 11.

More specifically, the aromatic tetravalent functional group having 9 or more and 15 or less carbon atoms may be a functional group represented by the following Chemical Formula 11-1.

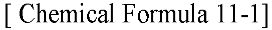

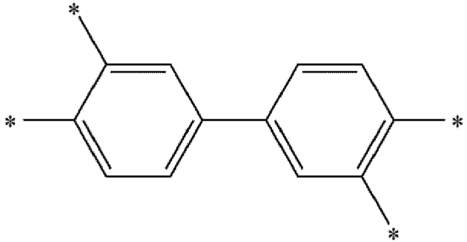

That is, the polyimide polymer is a functional group derived from a tetracarboxylic dianhydride compound used in the synthesis of the polyimide polymer, and may include a repeating unit including a tetravalent functional group represented by Chemical Formula 6, a polyimide repeating unit including an aromatic tetravalent functional group having 8 or less carbon atoms including a functional group represented by Chemical Formula 10, and a polyimide repeating unit including an aromatic tetravalent functional group having 9 or more and 15 or less carbon atoms including a functional group represented by Chemical Formula 11.

This is a tetracarboxylic dianhydride compound used in the synthesis of polyimide polymer during the synthesis of polyimide polymer, and can be implemented by using a mixture of a tetracarboxylic dianhydride compound containing the tetravalent functional group represented by Chemical Formula 6, a tetracarboxylic dianhydride compound containing the functional group represented by Chemical Formula 10, and a tetracarboxylic dianhydride compound containing the functional group represented by Chemical Formula 11.

That is, the polymer may include a first repeating unit containing a repeating unit including at least one selected from the group consisting of the repeating unit represented by Chemical Formula 1, the repeating unit represented by Chemical Formula 2, and the repeating unit represented by Chemical Formula 2, wherein the tetracarboxylic dianhydride-derived functional group is the tetravalent functional group represented by Chemical Formula 6; a second repeating unit containing a polyimide repeating unit represented by Chemical Formula 4, wherein the tetracarboxylic dianhydride-derived functional group is an aromatic tetravalent functional group having 8 or less carbon atoms; and a third repeating unit containing a polyimide repeating unit represented by Chemical Formula 5, wherein the tetracarboxylic dianhydride-derived functional group is an aromatic tetravalent functional group having 9 or more and 15 or less carbon atoms. The first to third repeating units can be randomly arranged in the polyimide-based polymer to form a random copolymer, or can form a block between the first repeating units, a block between the second repeating units, and a block between the third repeating units to produce a block copolymer.

The polymer including the first repeating unit to the third repeating unit can be prepared by reacting three or more types of different tetracarboxylic dianhydride compounds with a diamine compound, and the three types of tetracarboxylic dianhydrides can be added simultaneously to synthesize a random copolymer, or can be added sequentially to synthesize a block copolymer.

Meanwhile, the polyimide polymer can contain the polyimide repeating unit represented by Chemical Formula 4 in an amount of 51 mol% or more and 90 mol% or less with respect to 100 mol% of the total repeating unit.

When the polymer contains the polyimide repeating unit represented by Chemical Formula 4 in an amount of less than 51 mol%, the coefficient of thermal expansion appears as 35 ppm/°C or more which may lead to reduction in heat resistance. When the polyimide repeating unit represented by Chemical Formula 4 is contained in an amount of more than 90 mol%, there may be a problem that the optical properties are remarkably deteriorated.

Within the above-mentioned numerical range, the polyimide polymer film synthesized from the polyimide polymer can simultaneously satisfy the features that the glass transition temperature is 400°C or more, the coefficient of thermal expansion measured by raising the temperature in the temperature range of 100°C or more and 400°C or less is -10 ppm/°C or more and 30 ppm/°C or less, and the transmittance at a wavelength of 450 nm at a thickness of 10 µm is 70% or more and 99% or less.

Further, the polyimide polymer may contan a repeating unit including at least one selected from the group consisting of the repeating unit represented by Chemical Formula 1, the repeating unit represented by Chemical Formula 2, and the repeating unit represented by Chemical Formula 3 in an amount of 5 mol% or more and 20 mol% or less, 10 mol% or more and 15 mol% or less, 10 mol% or more and 13 mol% or less, 10 mol% or more and 12.5 mol% or less, or 10 mol% or more and 12 mol% or less with respect to 100 mol% of the total repeat units.

When the polyimide polymer contans a repeating unit including at least one selected from the group consisting of the repeating unit represented by Chemical Formula 1, the repeating unit represented by Chemical Formula 2, and the repeating unit represented by Chemical Formula 3 in an amount of less than 5 mol%, there may be technical problems that optical properties such as haze, yellowness, and transmittance are poor, and heat resistance is also deteriorated.

Within the above-mentioned numerical range, the polyimide polymer film synthesized from the polyimide polymer can simultaneously satisfy the features that the glass transition temperature is 400°C or more, the coefficient of thermal expansion measured by raising the temperature in the temperature range of 100°C or more and 400°C or less is -10 ppm/°C or more and 30 ppm/°C or less, and the transmittance at a wavelength of 450 nm at a thickness of 10 µm is 70% or more and 99% or less.

Meanwhile, the polymer may contain the polyimide repeating unit represented by Chemical Formula 5 in an amount of 1 mol% or more and 40 mol% or less, 5 mol% or more and 40 mol% or less, 5 mol% or more and 35 mol% or less.

As the polymer contains the polyimide repeating unit represented by Chemical Formula 5 in an amount of 1 mol% or more and 40 mol% or less, the polymer may exhibit excellent optical properties and at the same time realize high heat resistance.

Within the above-mentioined numerical range, the polyimide polymer film synthesized from the polyimide polymer can simultaneously satisfy the features that the glass transition temperature is 400°C or more, the coefficient of thermal expansion measured by raising the temperature in the temperature range of 100°C or more and 400°C or less is -10 ppm/°C or more and 30 ppm/°C or less, and the transmittance at a wavelength of 450 nm at a thickness of 10 µm is 70% or more and 99% or less.

A repeating unit containing at least one selected from the group consisting of the repeating unit represented by Chemical Formula 1, the repeating unit represented by Chemical Formula 2 and the repeating unit represented by Chemical Formula 3, the polyimide repeating unit represented by Chemical Formula 4 and the polyimide repeating unit represented by Chemical Formula 5 can be contained in an amount of 70 mol% or more, or 80 mol% or more, or 90 mol% or more, or 70 mol% or more and 100 mol% or less, 80 mol% or more and 100 mol% or less, 70 mol% or more and 90 mol% or less, 70 mol% or more and 99 mol% or less, 80 mol% or more and 99 mol% or less, 90 mol% or more and 99 mol% or less with respect to the total repeating units contained in the polyimide polymer.

That is, the polyimide polymer is composed of only a repeating unit containing at least one selected from the group consisting of the repeating unit represented by Chemical Formula 1, the repeating unit represented by Chemical Formula 2 and the repeating unit represented by Chemical Formula 3, the polyimide repeating unit represented by Chemical Formula 4 and the polyimide repeating unit represented by Chemical Formula 5, or most thereof can be composed of a repeating unit containing at least one selected from the group consisting of the repeating unit represented by Chemical Formula 1, the repeating unit represented by Chemical Formula 2 and the repeating unit represented by Chemical Formula 3, the polyimide repeating unit represented by Chemical Formula 4 and the polyimide repeating unit represented by Chemical Formula 5.

More specifically, the polyimide polymer may not be mixed with other diamines in addition to diamines capable of inducing aromatic divalent functional groups atoms in which at least one fluorine-based functional group is substituted, or may be mixed in an extremely small amount of less than 1 mol%.

Meanwhile, the polyimide polymer film may include a compound represented by the following Chemical Formula 9. 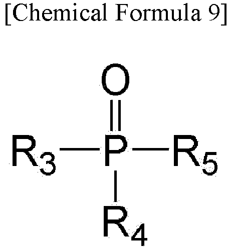 wherein, in Chemical Formula 9, R₃ to R₅ are each independently hydrogen, a hydroxyl group, an alkyl group, or an aryl group.

Specifically, in Chemical Formula 9, R₃ to R₅ may be each independently an aryl group.

For example, the compound represented by Chemical Formula 9 may include a compound represented by the following Chemical Formula 9-1.

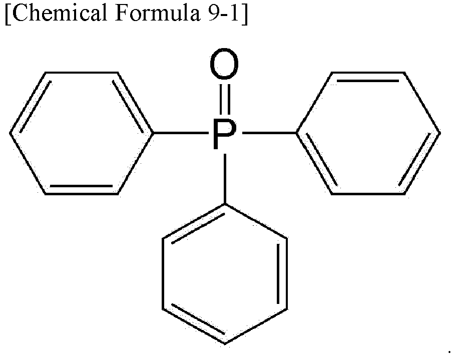

Meanwhile, the compound represented by Chemical Formula 9 may be contained in an amount of 0.5% by weight or more and 20% by weight or less with respect to the total weight of a polymer solid content.

Within the above-mentioned numerical range, the polyimide polymer film can simultaneously satisfy the features that the glass transition temperature is 400°C or more, the coefficient of thermal expansion measured by raising the temperature in the temperature range of 100°C or more and 400°C or less is -10 ppm/°C or more and 30 ppm/°C or less, and the transmittance at a wavelength of 450 nm at a thickness of 10 µm is 70% or more and 99% or less.

Meanwhile, the polyimide polymer film may have the features that the transmittance at wavelengths of 450 nm and 550 nm is 70% or more, respectively, the coefficient of thermal expansion in the temperature range of 100 °C or more and 400 °C or less is -10 ppm/°C or more and 30 ppm/°C or less, and the glass transition temperature is 400 °C or more.

Examples of the method for measuring the glass transition temperature are not particularly limited, but for example, using a thermomechanical analyzer (TMA Q400 from TA Instruments), a force of pulling a film is set to 0.2N, and the first heating process is performed at a temperature raising rate of 5°C/min in a temperature range of 100 to 400°C, and then an inflection point appearing in the heating section in the first heating process can be determined as Tg.

In addition, for the polyimide polymer film, the coefficient of thermal expansion measured by raising the temperature in the temperature range of 100°C or more and 400°C or less may be -10 ppm/°C or more, and 0 ppm/°C or more, may be 30 ppm/°C or less, 25 ppm/°C or less, and 23 ppm/°C or less, and may be -10 ppm/°C or more and 30 ppm/°C or less, or -10 ppm/°C or more and 25 ppm/°C or less, or -10 ppm/°C or more and 23 ppm/°C or less, or 0 ppm/°C or more and 23 ppm/°C or less.

The coefficient of thermal expansion is determined by measuring the change in thermal expansion using TMA Q400 (TA Instruments) at the time when a force pulling a polyimide film sample is set to 0.2 N or less and the temperature is raised at a rate of 1°C/min or more and 10°C/min or less, or 4°C/min or more and 6°C/min or less in a temperature range including a temperature section of 100°C to 400°C.

As described above, as the polyimide polymer film has a low coefficient of thermal expansion, it can relax deformation caused by heat and improve heat resistance. When this is as a plastic substrate, it can prevent the plastic substrate from being damaged by heat when heat-treating the metal layer formed on the plastic substrate, and it can also suppress the occurrence of warpage in the metal thin film formed on the plastic substrate.

The polyimide film may have a yellow index YI of 10 µm of 1.0 or more and 25.0 or less at a thickness of 10 µm. When the yellow index YI at a thickness of 10 µm of the polyimide polymer film is excessively increased to more than 25.0, there is a limit in that the degree of yellowing of the polyimide film increases, making it difficult to produce a colorless and transparent film.

Examples of the method and device for measuring the YI according to the one embodiment are not specifically limited, and various methods conventionally used for the measurement of the YI can be applied without limitation. As an example, it can be measured using a color meter (Color-Eye 7000A from GRETAGMACBETH).

Further, the polyimide polymer film may have a transmittance of 70% or more at wavelengths of 450 nm and 550 nm, respectively.

Specifically, the transmittance of the polyimide film at a wavelength of 450 nm at a thickness of 10 µm may be 70% or more, 71% or more, may be 99% or less, 95% or less, or 80% or less, and may be 70% or more and 99% or less, 71% or more and 99% or less, 71% or more and 95% or less, and 71% or more and 80% or less. When the transmittance of the polyimide polymer film at a wavelength of 450 nm at a thickness of 10 µm is less than 70%, there is a limit in that the degree of yellowing of the polyimide film increases, making it difficult to produce a colorless and transparent film.

Further, the transmittance of the polyimide film more at a wavelength of 550 nm at a thickness of 10 µm may be 70% or more, 80% or more, 85% or more, 88% or more, may be 99% or less, 95% or less, or 90% or less, and may be 70% or more and 99% or less, 80% or more and 99% or less, 85% or more and 99% or less, 88% or more and 95% or less, 88% or more and 90% or less. When the transmittance of the polyimide polymer film at a wavelength of 550 nm at a thickness of 10 µm is less than 70%, there is a limit in that the degree of yellowing of the polyimide film increases, making it difficult to produce a colorless and transparent film.

Examples of the method and equipment for measuring the transmittance according to the one embodiment are not specifically limited, and various methods conventionally used for measuring the transmittance can be applied without limitation. As an example, the transmittance (T) can be measured according to the measurement method of JIS K 7105 using a UV-vis spectroscopy (model name: HR-100, Murakami Color Research Laboratory) device.

Further, the polyimide polymer film may have a Td 1% of 500°C or more, or 550°C or more, and it may be 600°C or less, 554°C or less, or 500°C or more and 600°C or less, 550°C or more and 600°C or less, 550°C or more and 554°C or less. The Td 1% may be realized as the polyimide polymer film of the embodiment includes the above-mentioned polyimide polymer.

The Td 1% may mean a temperature when the weight reduction rate for the initial polyimide polymer film is 1%, and is not particularly limited, but for example, it can be measured using the Discovery TGA from TA Instruments.

Further, the polyimide polymer film may have an elongation of 15% or more, 16% or more, 25% or less, 24% or less, and it may also be 15% or more and 25% or less, 15% or more and 24% or less, or 16% or more and 24% or less. The elongation may be realized as the polyimide polymer film of the embodiment includes the above-mentioned polyimide polymer.

The elongation is measured by preparing a sample with a size of 5 mm * 100 mm and a thickness of 10 µm with respect to the polyimide polymer film of the embodiment, and measuring the distance between grips at a speed of 30 mm and 10 mm/min using Instron's 3365 model equipment.

Further, the polyimide polymer film may have a tensile strength of 215 MPa or more, 218 MPa or more, and it may also be 350 MPa or less, 330 MPa or less, 320 MPa or less, and may be 215 MPa or more and 350 MPa or less, 215 MPa or more and 330 MPa or less, 215 MPa or more and 320 MPa or less, or 218 MPa or more and 320 MPa or less. The tensile strength may be realized as the polyimide polymer film of the embodiment includes the above-mentioned polyimide polymer.

The tensile strength is measured by preparing a sample with a size of 5 mm * 100 mm and a thickness of 10 *µ*m with respect to the polyimide polymer film of the embodiment, and measuring the distance between grips at a speed of 30 mm and 10 mm/min using Instron's 3365 model equipment.

Further, the polyimide polymer film may have a tensile modulus of 5.3 GPa or more, 5.5 GPa or more, may be 7.0 GPa or less, 6.8 GPa or less, 6.7 GPa or less, and it may be 5.3 GPa or more and 7.0 GPa or less, 5.3 GPa or more and 6.8 GPa or less, and may be 5.5 GPa or more and 6.8 GPa or less, or 5.5 GPa or more and 6.7 GPa or less. The tensile modulus may be realized as the polyimide polymer film of the embodiment includes the above-mentioned polyimide polymer.

The tensile modulus can be determined by preparing a sample with a size of 5 mm * 100 mm and a thickness of 10 µm with respect to the polyimide polymer film of the embodiment, and measuring the distance between grips at a speed of 30 mm and 10 mm/min using Instron model 3365 equipment.

The weight average molecular weight (measured by GPC) of the polyimide polymer is not particularly limited, but for example, it may be 1000 g/mol or more and 200000 g/mol or less, or 10000 g/mol or more and 200000 g/mol or less.

The polyimide polymer according to the present disclosure can exhibit excellent colorless and transparent properties while maintaining the properties such as heat resistance and mechanical strength due to a rigid structure as they are, and thus can be used in various fields such as a substrate for device, a cover substrate for display, an optical film, IC (integrated circuit) package, an adhesive film, a multi-layer flexible printed circuit (FRC), a tape, a touch panel, a protective film for optical disk, and the like.

More specifically, the example of the method for synthesizing the polyimide polymer film is not particularly limited, and for example, a method of producing a film including a step of coating a resin composition containing the polyimide polymer onto a substrate to form a coating film (step 1); a step of drying the coating film (step 2); and a step of heat-treating and curing the dried coating film (step 3) can be used.

Step 1 is a step of coating the resin composition containing the above-mentioned polyimide polymer onto a substrate to form a coating film. The method of coating the resin composition containing the polyimide polymer onto a substrate is not particularly limited, and for example, a method such as screen printing, offset printing, flexographic printing, inkjet, and the like can be used.

Further, the resin composition containing the polyimide polymer may be in the form that is dissolved or dispersed in an organic solvent. In the case of having such form, for example, when the polyimide polymer is synthesized in the organic solvent, the solution may be the reaction solution thus obtained itself or may be a solution obtained by diluting the reaction solution with another solvent. Further, when the polyimide polymer is obtained as powder, the solution may be a solution obtained by dissolving the powder in an organic solvent.

Specific examples of the organic solvent include N,N-dimethylformamide, N,N-dimethylacetamide, N-methyl-2-pyrrolidone, N-methylcaprolactam, 2-pyrrolidone, N-ethylpyrrolidone, N-vinylpyrrolidone, dimethylsulfoxide, tetramethylurea, pyridine, dimethyl sulfone, hexamethyl sulfoxide, γ-butyrolactone, 3-methoxy-N,N-dimethylpropanamide, 3-ethoxy-N,N-dimethylpropanamide, 3-butoxy-N,N-dimethylpropanamide, 1,3-dimethyl-imidazolidinone, ethyl amyl ketone, methyl nonyl ketone, methyl ethyl ketone, methyl isoamyl ketone, methyl isopropyl ketone, cyclohexanone, ethylene carbonate, propylene carbonate, diglyme, 4-hydroxy-4-methyl-2-pentanone, ethylene glycol monomethyl ether, ethylene glycol monomethyl ether acetate, ethylene glycol monoethyl ether, ethylene glycol monoethyl ether acetate, ethylene glycol monopropyl ether, ethylene glycol monopropyl ether acetate, ethylene glycol monoisopropyl ether, ethylene glycol monoisopropyl ether acetate, ethylene glycol monobutyl ether, ethylene glycol monobutyl ether acetate and the like. They can be used alone or in combination of two or more.

The resin composition containing the polyimide-based polymer may include the solid in such an amount that the solution has an appropriate viscosity in consideration of processability such as a coating property during the film forming process. For example, the content of the composition may be adjusted so that the total content of the resin is 5% by weight or more and 25% by weight or less, or may be adjusted to 5% by weight or more and 20% by weight or less, or 5% by weight or more and 15% by weight or less.

In addition, the resin composition containing the polyimide polymer may further include other components in addition to the organic solvent. In a non-limiting example, when the resin composition containing the polyimide polymer is coated, additives capable of improving the uniformity of the film thickness and the surface smoothness, or improving the adhesion with a substrate, or changing the dielectric constant and conductivity, or increasing the denseness, may be further included. Examples of these additives include surfactants, silane-based compounds, dielectrics or crosslinking compounds, and the like.

Step 2 is a step of drying the coating film formed by coating a resin composition containing the polyimide polymer onto a substrate.

The step of drying the coating film may be performed by a heating means such as a hot plate, a hot-air circulation furnace, an infrared furnace and the like, and the drying may be performed at a temperature of 50°C or more and 150°C or less, or 50°C or more and 100°C or less.

Step 3 is a step of heat-treating and curing the dried coating film. In this case, the heat treatment may be performed by a heating means such as a hot plate, a hot-air circulation furnace, an infrared furnace and the like, and the heat treatment can be performed at a temperature of 200°C or more, or 200°C or more and 300°C or less.

The thickness of the polyimide polymer film is not particularly limited, but for example, it can be freely adjusted within the range of 0.01 *µ*m or more and 1000 *µ*m or less. If the thickness of the polyimide polymer film increases or decreases by a specific value, the physical properties measured in the polyimide polymer film may also change by a certain value.

Meanwhile, according to another embodiment of the present disclosure, there can be provided a substrate for display device including the polyimide-based polymer film of the other embodiment. Details of the polyimide polymer film may include all of the contents described above in the one embodiment.

The display device including the substrate may include a liquid crystal display device (LCD), an organic light emitting diode (OLED), a flexible display), a rollable display or foldable display, or the like, but is not limited thereto.

The display device may have various structures according to an application field and a specific shape, and may include, for example, a cover plastic window, a touch panel, a polarizing plate, a barrier film, a light emitting device (such as an OLED device), a transparent substrate, or the like.

The polyimide polymer film of another embodiment described above may be used in various applications such as a substrate, an outer protective film or a cover window in such various display devices, and more specifically, may be applied to a substrate.

For example, the display device substrate may have a structure in which a device protective layer, a transparent electrode layer, a silicon oxide layer, a polyimide polymer film, a silicon oxide layer, and a hard coating layer are sequentially stacked.

The transparent polyimide substrate may further include a silicon oxide layer formed between the transparent polyimide polymer film and the cured layer in order to further improve the solvent resistance, water permeability and optical properties thereof, and the silicon oxide layer may be produced by curing polysilazane.

Specifically, the silicon oxide layer may, before the step of forming a coating layer on at least one surface of the transparent polyimide polymer film, be formed by curing the coated polysilazane after coating and drying a solution containing polysilazane

The substrate for a display device according to the present disclosure includes the above-mentioned device protective layer and thereby, can provide a transparent polyimide cover substrate having solvent resistance, optical properties, water permeability and scratch resistance while having excellent warpage properties and heat resistance.

Meanwhile, according to another embodiment of the present disclosure, there can be provided a flexible display device including the polyimide polymer film of the other embodiment. Details of the polyimide polymer film may include all of those described above in the one embodiment.

The flexible display device may include all kinds of devices using properties realized by light, and may be, for example, a display device. Specific examples of the display device include a liquid crystal display device (LCD), an organic light emitting diode (OLED), a flexible display, a rollable display or foldable display device, or the like, but is not limited thereto.

The flexible display device can have various structures according to the application field and the specific shape, and for example, it can have a structure including a cover plastic window, a touch panel, a polarizing plate, a barrier film, a light emitting device (such as an OLED device), a transparent substrate, or the like.

The polyimide polymer film of another embodiment described above may be used in various applications such as a substrate, an outer protective film or a cover window in various optical devices, and more specifically, may be applied to a substrate.

### [ADVANTAGEOUS EFFECTS]

According to the present disclosure, a polyimide polymer film capable of realizing excellent optical properties and high heat resistance, a substrate for flexible display device and a flexible display device using the same can be provided.

### [DETAILED DESCRIPTION OF THE EMBODIMENTS]

Hereinafter, embodiments of the present disclosure will be described in more detail by way of examples. However, these examples are provided for illustrative purposes only, and are not intended to limit the scope of the present disclosure.

### <Examples and Comparative Examples: Preparation of polyimide precursor composition and polyimide film>

### Example 1

### (1) Preparation of polyimide precursor composition

The organic solvent DEAc was filled in a reactor under a stream of nitrogen, and then in a state where the temperature of the reactor was maintained at 25°C, 2,2'-bis(trifluoromethyl)benzidine (TFMB) was added and dissolved at the same temperature. Pyromellitic dianhydride (PMDA), 9,9-bis(3,4-dicarboxyphenyl)fluorene dianhydride (BPAF) and 3,3',4,4'-biphenyltetracarboxylic dianhydride (BPDA) were added at the same temperature and stirred for 48 hours to obtain a polyimide precursor composition. At this time, the molar ratio of each added monomer is as shown in Table 1 below.

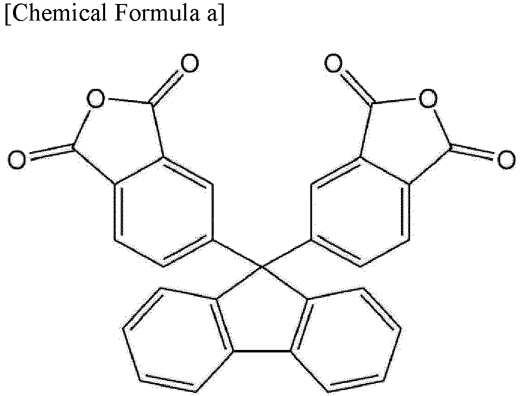

### (2) Preparation of Polyimide Film

The polyimide precursor composition was spin coated on a glass substrate. The polyimide precursor composition-coated glass substrate was put in an oven and heated at a speed of 5°C/min, and a curing process was performed by maintaining at 80°C for 5 to 30 minutes, at 250°C for 30 minutes, and at 400°C for 30 to 40 minutes.

After completion of the process, the glass substrate was immersed in water to remove the film formed on the glass substrate and dried in an oven at 100°C to produce a polyimide film having a thickness of 10 µm.

### Examples 2~5 and Comparative Examples 1~2

A polyimide precursor composition and a polyimide film were produced in the same manner as in Example 1, except that the molar ratio of each monomer was changed as shown in Table 1 below.

### Examples 6~10 and Comparative Examples 3~4

A polyimide precursor composition and a polyimide film were produced in the same manner as in Example 1, except that the molar ratio of each monomer was changed as shown in Table 1 below, and triphenylphosphine oxide (TPPO) was added to the produced polyimide precursor composition in an amount of 2 wt% with respect to the total solid content.

**[Table 1]**

| Category | PMDA (mol%) | BPDA (mol%) | BPAF (mol%) | TFMB (mol%) | TPPO (wt%) |
|---|---|---|---|---|---|
| Example 1 | 55 | 35 | 10 | 99.9 | - |
| Example 2 | 60 | 30 | 10 | 99.9 | - |
| Example 3 | 65 | 25 | 10 | 99.9 | - |
| Example 4 | 70 | 20 | 10 | 99.9 | - |
| Example 5 | 80 | 5 | 15 | 99.9 | - |
| Example 6 | 55 | 35 | 10 | 99.9 | 2 |
| Example 7 | 60 | 30 | 10 | 99.9 | 2 |
| Example 8 | 65 | 25 | 10 | 99.9 | 2 |
| Example 9 | 70 | 20 | 10 | 99.9 | 2 |
| Example 10 | 80 | 5 | 15 | 99.9 | 2 |
| Comparative Example 1 | 45 | 45 | 10 | 99.9 | - |
| Comparative Example 2 | 50 | 49 | 10 | 99.9 | - |
| Comparative Example 3 | 45 | 45 | 10 | 99.9 | 2 |
| Comparative Example 4 | 20 | 75 | 1 | 99.9 | 2 |

| | | | | | |
|---|---|---|---|---|---|
| ^{∗} PMDA: pyromellitic dianhydride ^{∗} BPDA: 3,3',4,4'-biphenyltetracarboxylic dianhydride ^{∗} BPAF: 9,9-bis(3,4-dicarboxyphenyl)fluorene dianhydride ^{∗} TFMB: 2,2'-bis(trifluoromethyl)benzidine ^{∗} TPPO: triphenylphosphine oxide | | | | | |

### <Experimental Example: Measurement of Physical Properties of Polyimide Precursor Compositions and Polyimide Films Obtained in Examples and Comparative Examples>

The physical properties of the polyimide precursor compositions and polyimide films obtained in Examples and Comparative Examples were measured by the following methods, and the results are shown in Table 2 below.

### 1. Coefficient of Thermal Expansion (CTE) and Glass Transition Temperature (Tg)

The polyimide films obtained in Examples and Comparative Examples were prepared in a size of 5 mm × 20 mm, and then the samples were then loaded with an accessory. The actually measured length of the film was set equally to 16 mm. The coefficient of linear thermal expansion of the polyimide-based film was measured as an average value in the range of 100 to 400°C from the growth of the test sample at a load of 0.2 N/film thickness of 10 µm and a heating speed of 5°C/min. At this time, the inflection point appearing the heating section in the first heating process was determined as Tg.

### 2. Transparency

With respect to the polyimide films produced in Examples and Comparative Examples, the ligh transmittance (T) at wavelengths of 450 nm and 550 nm was measured according to the measurement method of JIS K 7105 using UV-vis spectroscopy (model name: HR-100, Murakami Color Research Laboratory) equipment, and the results are shown in Table 2 below.

### 3. Thermal Decomposition Temperature (Td 1%)

With respect to the polyimide films produced in Examples and Comparative Examples, the temperature when the weight reduction rate of the first polyimide film was 1% was measured in a nitrogen atmosphere using Discovery TGA manufactured by TA Instruments, and the results are shown in Table 2 below.

### 4. Elongation, Tensile Strength and Tensile Modulus

With respect to the polyimide films produced in Examples and Comparative Examples, a sample with a size of 5 mm ^{∗} 100 mm and a thickness of 10*µ*m was prepared using Instron model 3365 equipment, and the elongation (%), tensile strength (MPa) and tensile modulus (GPa) were measured by setting the distance between grips to 30mm and the speed of each resin film to 10 mm/min, and the results are shown in Table 2 below.

**[Table 2]**

| Experimental Example Measurement Results of Examples and Comparative Examples | | | | | | | | |
|---|---|---|---|---|---|---|---|---|
| Category | CTE (ppm/°C ) | Tg (°C) | Transmittanc e (%) @450 nm | Transmittanc e (%) @550 nm | Td 1% | Elongatio n (%) | Tensile strengt h (MPa) | Tensile modulu s (GPa) |
| Example 1 | 19 | >40 0 | 76 | 87 | 55 0 | 20 | 299 | 5.5 |
| Example 2 | 14 | >40 0 | 73 | 86 | 55 0 | 24 | 281 | 6.0 |
| Example 3 | 9 | >40 0 | 73 | 86 | 55 2 | 20 | 271 | 6.2 |
| Example 4 | 5 | >40 0 | 71 | 86 | 55 | 17 | 261 | 6.6 |
| Example 5 | 6 | >40 0 | 73 | 86 | 55 2 | 24 | 263 | 6.7 |
| Example 6 | 23 | >40 0 | 77 | 87 | 55 4 | 19 | 230 | 5.6 |
| Example 7 | 16 | >40 0 | 76 | 87 | 55 4 | 20 | 263 | 6.0 |
| Example 8 | 11 | >40 0 | 75 | 87 | 55 4 | 16 | 218 | 6.3 |
| Example 9 | 7 | >40 0 | 75 | 87 | 55 4 | 24 | 317 | 6.7 |
| Example 10 | 8 | >40 0 | 76 | 87 | 55 4 | 18 | 277 | 6.7 |
| Comparativ e Example 1 | 36 | >40 0 | 76 | 87 | 55 0 | 21 | 168 | 5.0 |
| Comparativ e Example 2 | 40 | >40 0 | 80 | 88 | 55 0 | 19 | 214 | 5.2 |
| Comparativ e Example 3 | 42 | >40 0 | 79 | 88 | 55 2 | 16 | 193 | 5.0 |
| Comparativ e Example 4 | 77 | >40 0 | 83 | 88 | 55 2 | 19 | 153 | 4.0 |

As shown in Table 2, it was confirmed that the polyimide films obtained in Examples exhibits excellent optical properties and a small coefficient of thermal expansion, and suppresses shrinkage and expansion at high temperatures, and further is excellent in mechanical physical properties such as mechanical strength and tensile modulus as well as heat resistance.

In contrast, it can be confirmed that the polyimide films of Comparative Examples are inferior in optical properties and heat resistance as compared with Examples, in particular, have a large coefficient of thermal expansion and thus are significantly inferior not only in heat resistance such as the occurrence of shrinkage and expansion at high temperature but also in mechanical properties such as tensile strength and tensile modulus.

## Claims

**1.** A polyimide polymer film comprising: a polyimide polymer which comprises a repeating unit derived from a reaction product between three or more aromatic tetracarboxylic acids having different structures or derivatives thereof and aromatic diamines,
wherein a transmittance at wavelengths of 450 nm and 550 nm is 70% or more, respectively,
a coefficient of thermal expansion in the temperature range of 100°C or more and 400°C or less is -10 ppm/°C or more and 30 ppm/°C or less, and
a glass transition temperature is 400°C or more.

**2.** The polyimide polymer film of claim 1, wherein:
the polyimide polymer comprises,
a repeating unit containing at least one selected from the group consisting of a repeating unit represented by the following Chemical Formula 1, a repeating unit represented by the following Chemical Formula 2, and a repeating unit represented by the following Chemical Formula 3;
a polyimide repeating unit represented by the following Chemical Formula 4; and
a polyimide repeating unit represented by the following Chemical Formula 5: 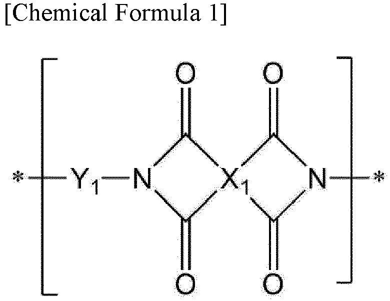 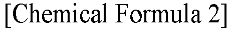 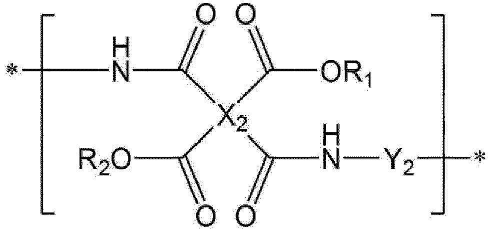 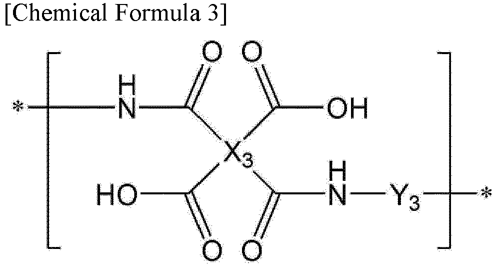
wherein, in Chemical Formulas 1 to 3,
at least one of R₁ and R₂ is an alkyl group having 1 to 10 carbon atoms, the rest is hydrogen,
X₁ to X₃ are each independently a tetravalent organic group including a tetravalent functional group represented by the following Chemical Formula 6,
wherein the Y₁ to Y₃ are each independently a divalent organic group substituted with at least one fluorine-based functional group, 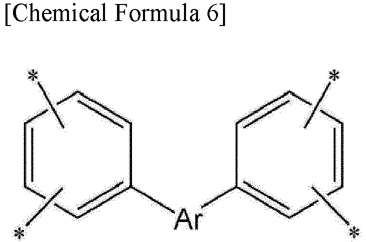
wherein, in Chemical Formula 6,
Ar is a polycyclic aromatic divalent functional group, 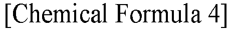 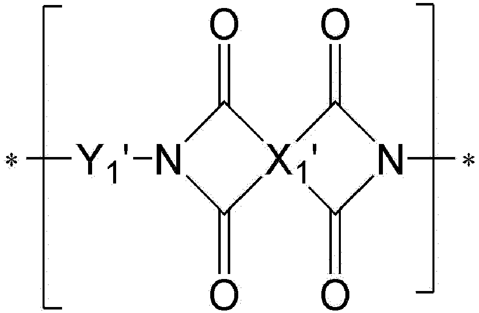
wherein, in Chemical Formula 4,
X₁' is an aromatic tetravalent functional group having 8 or less carbon atoms,
Y₁' is an aromatic divalent functional group substituted with at least one fluorine-based functional group, 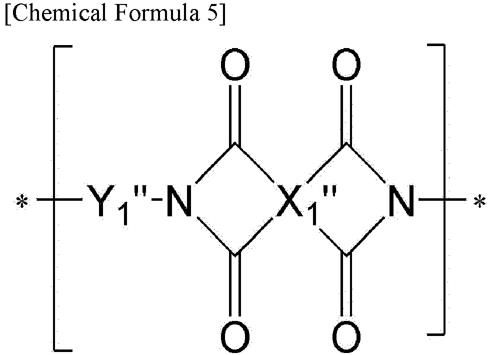
wherein, in Chemical Formula 5,
X₁" is an aromatic tetravalent functional group having 9 or more and 15 or less carbon atoms, and
Y₁" is an aromatic divalent functional group in which at least one fluorine-based functional group is substituted.

**3.** The polyimide polymer film of claim 2, wherein:
in Ar of Chemical Formula 6,
the polycyclic aromatic divalent functional group comprises a fused cyclic divalent functional group containing at least two or more aromatic ring compounds.

**4.** The polyimide polymer film of claim 2, wherein:
in Ar of Chemical Formula 6,
the polycyclic aromatic divalent functional group comprises a fluorenylene group.

**5.** The polyimide polymer film of claim 2, wherein:
the tetravalent functional group represented by Chemical Formula 6 comprises a functional group represented by the following Chemical Formula 6-1.

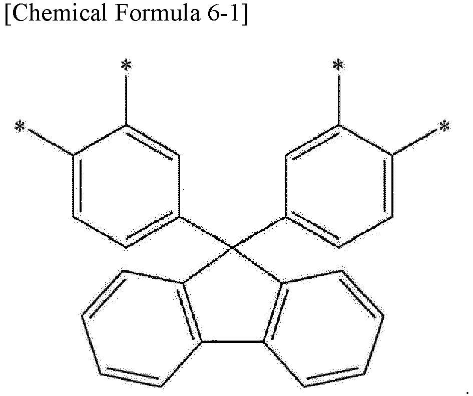

**6.** The polyimide polymer film of claim 2, wherein:
the aromatic tetravalent functional group having 8 or less carbon atoms comprises a functional group represented by the following Chemical Formula 10.

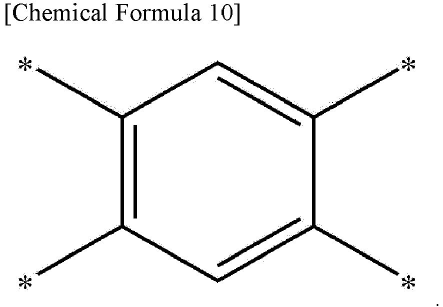

**7.** The polyimide polymer film of claim 2, wherein:
the aromatic tetravalent functional group having 9 or more and 15 or less carbon atoms comprises a functional group represented by the following Chemical Formula 11: 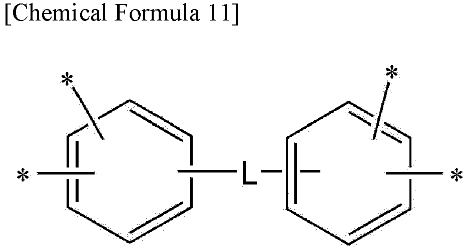
wherein, in Chemical Formula 11,
L is any one selected from the group consisting of a single bond, -O-, -CO-, - COO-, -S-, -SO-, -SO₂-, -CR₇R₈-, -(CH₂)ₜ-, -O(CH₂)ₜO-, -COO(CH₂)ₜOCO-, -CONH-, phenylene, or a combination thereof, and
t is an integer of 1 to 10;

**8.** The polyimide polymer film of claim 2, wherein:
the aromatic divalent functional group substituted with at least one fluorine-based functional group comprises a functional group represented by the following Chemical Formula 7: 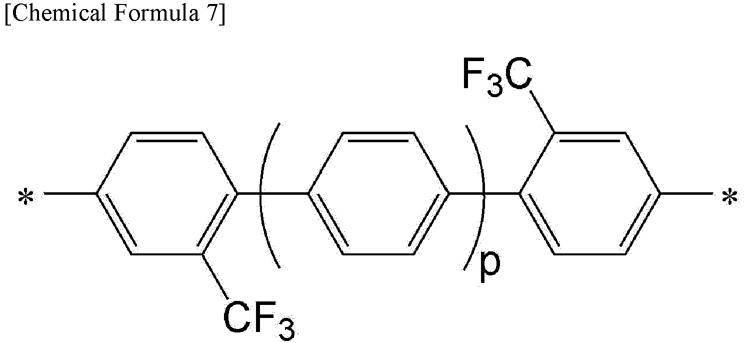
wherein, in Chemical Formula 7,
P is an integer of 0 or more and 5 or less.

**9.** The polyimide polymer film of claim 2, wherein:
the polyimide polymer includes 51 mol% or more and 90 mol% or less of the polyimide repeating unit represented by Chemical Formula 4 with respect to 100 mol% of the total repeating unit.

**10.** The polyimide polymer film of claim 9, wherein:
the polyimide polymer contains at least one selected from the group consisting of the repeating unit represented by Chemical Formula 1, the repeating unit represented by Chemical Formula 2, and the repeating unit represented by Chemical Formula 3 in an amount of 5 mol% or more and 20 mol% or less with respect to 100 mol% of the total repeating unit.

**11.** The polyimide polymer film of claim 10, wherein:
the polyimide polymer contains the polyimide repeating unit represented by Chemical Formula 5 in an amount of 1 mol% or more and 40 mol% or less with respect to 100 mol% of the total repeating unit.

**12.** The polyimide polymer film of claim 1, wherein:
the polyimide polymer film comprises a compound represented by the following Chemical Formula 9. 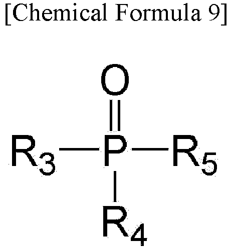
wherein, in Chemical Formula 9,
R₃ to R₅ are each independently hydrogen, a hydroxy group, an alkyl group or an aryl group..

**13.** The polyimide polymer film of claim 12, wherein:
the compound represented by Chemical Formula 9 comprises a compound represented by the following Chemical Formula 9-1.

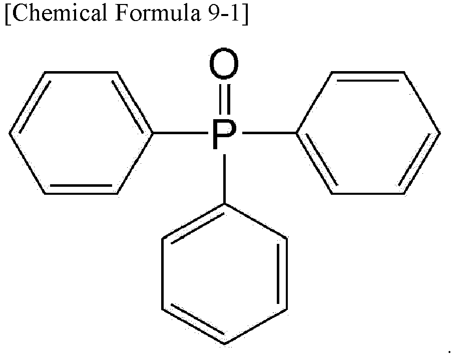

**14.** The polyimide polymer film of claim 12, wherein:
the compound represented by Chemical Formula 9 is contained in an amount of 0.5% by weight or more and 20% by weight or less with respect to the total weight of the polymer solid content.

**15.** A substrate for flexible display device comprising the polyimide polymer film of claim 1.

**15.** A flexible display device comprising the polyimide polymer film of claim 1.
